(19) Europäisches Patentamt

**European Patent Office**

**Office européen des brevets**

(11) Veröffentlichungsnummer: **0 219 517**
**B1**

(12) **EUROPÄISCHE PATENTSCHRIFT**

(45) Veröffentlichungstag der Patentschrift:
23.08.89

(51) Int. Cl.⁴: **B 23 K 35/363**, H 05 K 3/34

(21) Anmeldenummer: 86902371.3

(22) Anmeldetag: 14.03.86

(86) Internationale Anmeldenummer:
PCT/EP 86/00146

(87) Internationale Veröffentlichungsnummer:
WO 86/05428 (25.09.86 Gazette 86/21)

(54) **THERMOPLASTISCHES LÖTMITTEL, VERFAHREN UND VORRICHTUNG.**

(30) Priorität: 20.03.85 DE 3510000

(43) Veröffentlichungstag der Anmeldung:
29.04.87 Patentblatt 87/18

(45) Bekanntmachung des Hinweises auf die Patenterteilung:
23.08.89 Patentblatt 89/34

(84) Benannte Vertragsstaaten:
AT BE CH DE FR GB IT LI LU NL SE

(56) Entgegenhaltungen:
EP-A-0 034 530
DE-A-1 758 319
DE-A-2 164 865
DE-A-2 914 621
DE-A-3 010 610
FR-A-2 193 676
US-A-2 833 030

(73) Patentinhaber: **KAWE ELECTRONIC GMBH & CO. KG, Franz- Kleine- Strasse 13, D-4796 Salzkotten (DE)**

(72) Erfinder: **WENDISCH, Karl, Heinz, Franz- Kleine- Strasse 13, D-4796 Salzkotten (DE)**

(74) Vertreter: **Hanewinkel, Lorenz, Dipl.- Phys., Patentanwalt Ferrariweg 17a, D-4790 Paderborn (DE)**

## Beschreibung

Die Erfindung betrifft ein Lötmittel, bestehend aus einem ersten Anteil einer sehr feinkörnigen Blei-Zinn-Lötmetall-Legierung und aus einem zweiten Anteil eines organischen Bindemittel, das bei einer Verflüchtigungstemperatur oberhalb von 200°C praktisch rückstandslos zu verflüchtigen ist, und aus einem dritten Anteil eines Pastifizierungsmittel, das dem Lötmittel eine pastöse, siebdruckfähige Konsistenz mit einer vorgegebenen Topfzeit (Verarbeitungszeit) verleiht.

Ein Lötmittel dieser Art ist aus DE-A-2 164 865 bekannt. Es ist mit einem Pastifizierungs-und Bindemittel versetzt, das nach einer bestimmten Zeit von, im allgemeinen etwa 24 h, zu einer endgültigen Erhärtung des Lötmittels führt. Für die Herstellung von mit Bauelementen bestücktem Lötgut, insbesondere gedruckten Schaltungen, bedeutet dies, daß innerhalb der bestimmten Zeit das bekannte Mittel im Siebdruckverfahren auf das Lötgut aufgebracht werden muß und weiterhin die elektronischen Bauelemente aufgesetzt werden müssen. Es ist erforderlich, daß alle Bauelemente bereitstehen. Korrekturen und Nachbestückungen sind nicht möglich. Weiterhin ist nachteilig, daß die Bauelemente, solange das Bindemittel noch nicht verfestigt ist, nur durch Oberflächenkräfte zwischen dem Bindemittel und den Kontakten der Bauelemente in ihrer Position gehalten werden, was eine Erschwerung der Handhabung und Zwischenlagerung des bestückten Lötgutes mit sich bringt.

Nach einem weiteren bekannten Bestückungsverfahren werden die Bauelemente auf dem Lötgut mit einem Klebstoff befestigt, wobei die Kontakte der Bauelemente, die mit erhärtetem Lötmittel oder galvansich oder im Schwallbad aufgetragenen Lötmetall versehenen Schaltungen nur berühren. Diese Fixierung der Bauelemente mit dem Klebstoff hat außer, daß dazu ein spezieller Arbeitsgang erforderlich ist, den Nachteil, daß die Bauelemente nicht durch die Oberflächenkräfte, die bei dem Lötmittelverfahren zu den Kontakten der Bauelemente auftreten, in die vorgesehene Lötposition orientiert werden, so daß größere Lötpunkte notwendig und eine geringere Bestückungsdichte erreichbar sind.

Weiterhin ist aus DE-A-3 010 610 ein Blei-Zinn-Lötmittel bekannt, das Bindemittel und Terpineol sowie organische Flußmittel enthält, so daß es zum Siebdruck geeignet ist.

Wegen der Nachteile der bekannten Mittel haben sich die bekannten Verfahren zur Bestückung bedruckter Schaltungen unter deren Verwendung nur beschränkt durchgesetzt, obwohl große Vorteile in der Herstellung der Bauelemente und der zugehörigen Schaltungen für Oberflächenmontage dadurch gegeben sind, daß Anschlußdrähte an den Bauelementen und deren Vor- und Nacharbeit beim Bestücken entfallen und keine Aufnahmebohrungen dafür notwendig sind. Letzteres ermöglicht weiterhin eine höhere Flächennutzung. Insbesonders auch für automatische Bestückung eignet sich die Oberflächemontage, da das Einführen von Kontakten in eng tolerierte Bohrungen entfällt.

Es ist Aufgabe der Erfindung, ein Lötmittel und ein Verfahren zu dessen Verwendung zu offenbaren, das die Nachteile der bekannten vermeidet, indem zwischen dem Auftragen des Lötmittels auf das Lötgut eine beliebige Zeitspanne liegen kann, das Bestücken mit beliebigen zeitlichen Unterbrechungen erfolgen kann, die Bauelemente kurz nach dem Bestücken fest haften und durch Oberflächenkräfte zu den Lötpunkten orientiert werden.

Die Lösung der Aufgabe ist durch die Merkmale der unabhängigen Ansprüche 1a und 4 gegeben. Bevorzugte Ausführungsformen sind Gegenstand der abhängigen Ansprüche.

Ein besonderer Vorteil ist bei diesem Verfahren dadurch gegeben, daß die mit Lötmittel beschichteten unbestückten oder teilbestückten Schaltplatten oder mit Lötmittel versehene Bauelemente als Handelsware in den Verkehr gebracht werden können, so daß der Gerätehersteller, der die endgültige Bestückung der Schaltplatten vornimmt, keine Siebdruckanlage und auch keine teure Schwallötanlage, sondern nur beheizte Bestückungsvorrichtungen und eine Heizzonen-Lötvorrichtung, die wesentlich preiswerter und kleiner ist, benötigt. Sofern die Herstellung der Masken für die sogenannte gedruckte Schaltung und den Siebdruck des Lötmittels auf den gleichen Maskenerstellungsanlagen bei dem Hersteller der gedruckten Schaltungen erfolgt, lassen sich die geringst möglichen Toleranzen dazwischen zu erreichen.

Als Grundstoff des Lötmetallpulvers eignen sich die bekannten Blei-Zinn-Legierungen, die auch Wismut, Silber usw. enthalten könnten. Als Bindemittel bieten sich eine große Zahl von bekannten Stoffen an. Bevorzugt sind solche Bindemittel, die Flußmitteleigenschaften haben, also desoxydierend und benetzend wirken, jedoch nicht korrodierend sind.

Das Lötmittel kann durch Einrühren von Lötmetallpulver in verflüssigtes oder gelöstes Bindemittel hergestellt werden, oder es kann durch Mischung von Lötmetall- und Bindemittelpulver und nachträgliches Pastifizieren durch Lösungsmittelbeimischung gebrauchsfertig gemacht werden.

Die Pulvermischung mit separatem Pastifizierungsmittel ist eine bevorzugte Handelsform, da so eine gute Durchmischung des Metall-und des Bindemittelpulvers sichergestellt ist und nur ein einfacher Anrührvorgang zur Gebrauchsaufbereitung auszuführen ist.

Das Lötmittel läßt sich nicht nur für Oberflächenmontage von Bauelementen benutzen, sondern auch für Bauelemente in Durchsteckmontage und zur Verstärkung von durchkontaktierten Lochwänden. Es ergibt sich der Vorteil, daß kein Schwallötbad sondern nur eine Heizzone zum Löten erforderlich ist.

In den Fig. 1-5 sind Einzelheiten der Erfindung dargestellt.

Fig. 1 zeigt eine gedruckte Schaltung, ausschnittsweise vergrößert mit Lötmittel beschichtet in Aufsicht;

Fig. 2 zeigt die Schaltung Fig. 1, bestückt mit Bauelementen;

Fig. 3 zeigt ein mit Lötmittel beschichtetes Bauelement, perspektivisch;

Fig. 4 zeigt ein Bestückungs- und Heizpult in Perspektive,

Fig. 5 zeigt einen schematischen Verfahrensablauf.

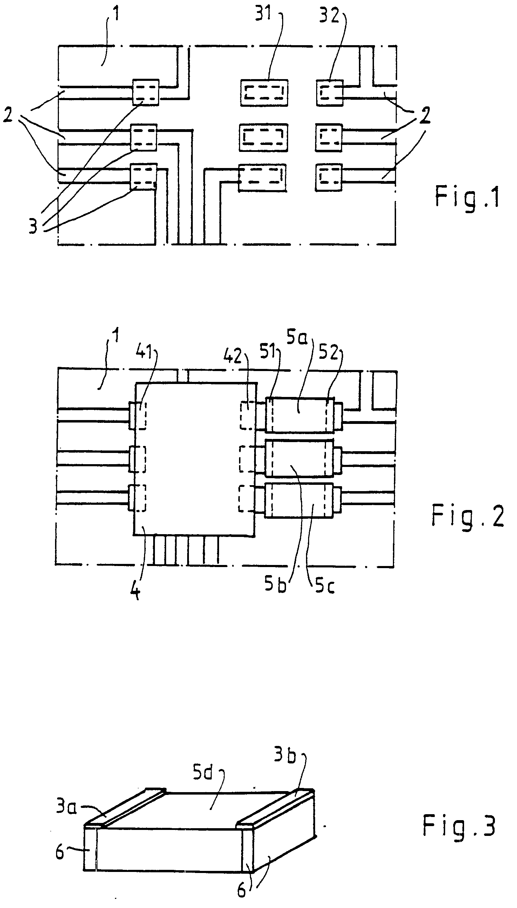

Fig. 1 zeigt einen vergrößerten Ausschnitt einer bekannten gedruckten Schaltungsplatte 1 mit Leiterbahnen 2 in einer vorgegebenen Anordnung. Auf als Lötstellen vorgesehenen Bereichen sind Lötmittelbeschichtungen 3, 31, 32 durch Siebdruck aufgebracht, die durch Verdampfen des Pastifizierungsmittels sowie Erkalten und Erstarren des thermoplastischen Bindemittels verfestigt sind.

Zum Bestücken wird diese Schaltungsplatte durch Strahlungswärme, Heißluft oder bevorzugt auf einer Heizplatte von unten über die Plastifizierungstemperatur aufgeheizt. In Fig. 2 ist gezeigt, wie Bauelemente 4, 5a, 5b, 5c verschiedener Bauart mit ihren Kontakten 41, 42, 51, 52 auf die Lötmittelbeschichtungen 3, 31, 32 aufgesetzt sind.

Durch die Oberflächenkräfte des Bindemittels orientieren sich die Bauelemente mit ihren Kontakten 51, 52 auf den Lötmittelflächen 31, 32 bis ein Kräftegleichgewicht symmetrisch entsteht. Dadurch können die Bauteile 5a, 5b, 5c eng nebeneinander liegen, ohne daß Kurzschlüsse entstehen. Eine gleiche Ausrichtung wird bei dem Lötvorgang durch die Oberflächenkräfte des Lotes beibehalten, wenn das Bindemittel verflüchtigt ist.

Fig. 3 zeigt eine für die Oberflächenmontage vorbereitetes quaderförmiges Bauelement 5d, z. B. einen Widerstand, eine Diode oder einen Kondensator. Dessen Endbereiche sind mit Kontaktmetall 6 beschichtet. Auf einer Fläche, die bei der Montage auf die Schaltungsplatte aufgesetzt wird, sind Lötmittelbeschichtungen 3a, 3b auf das Kontaktmetall 6 aufgebracht. Selbstverständlich kann auch die gesamte Kontaktfläche 6 mit Lötmittel beschichtet sein, so daß eine beliebige Orientierung bei der Bestückung gewählt werden kann. Allerdings muß der Abstand benachbarter Bauelemente dann etwas größer gewählt werden, um Kurzschlüsse zu vermeiden. Bei Verwendung dieser Bauelemente entfällt ein Siebdruckvorgang.

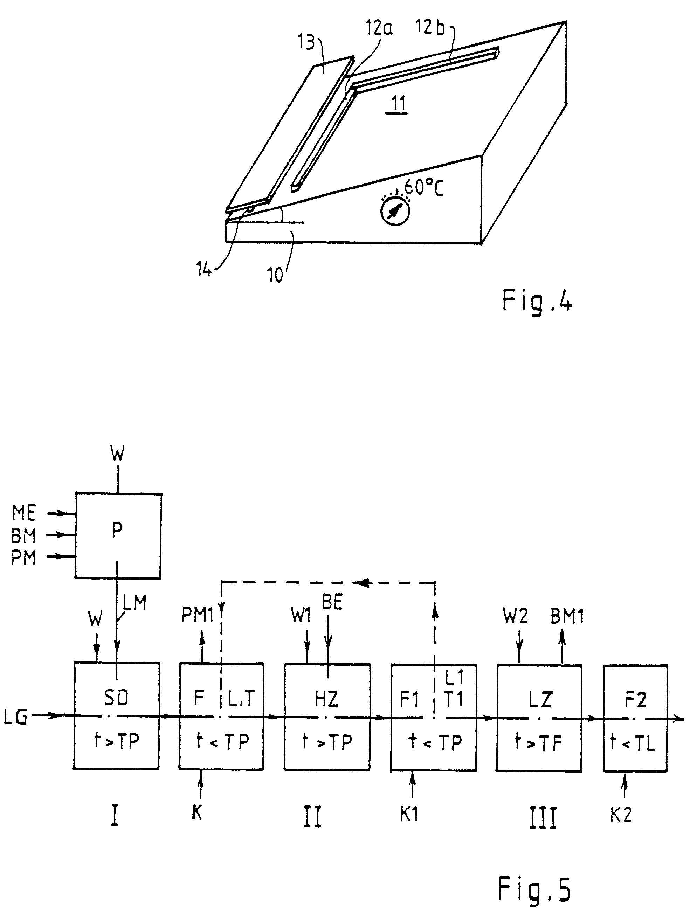

Fig. 4 zeigt eine Vorrichtung zur Durchführung des Verfahrensabschnittes der Bestückung. Auf einem pultartigen Gestell 10 ist im mittleren Bereich 11 einer thermostatisch beheizten Pultplatte der Arbeitsbereich zum Aufheizen der Schaltungsplatte und zur Bestückung. Der Neigungswinkel ist etwa 15° gegen die Horizontale, so daß eine gute Aufsicht gegeben ist. Der beheizte Bereich 11 ist an zwei Seiten mit einem Anschlag 12a, 12b begrenzt, so daß die Schaltungsplatte stets eine bestimmte Orientierung erhält. An der niedrig liegenden Pultplattenseite ist eine Arm-oder Handballenauflage 13 von etwa 10 cm Tiefe angeordnet. Sie ist zur besseren Wärmeisolation in einem Abstand von ca. 2 cm oder auch höhenverstellbar über dem Pult angebracht und besteht vorzugsweise aus Kunststoff oder Holz und hat eine elastische Auflagefläche, um Ermüdungen vorzubeugen. Die Auflage 13 ist im Buchsen 14 steckbar am Gestell 10 gelagert und kann so durch Abstandsstücke oder mit einem Feststeller in der Höhe verstellt oder gegen jeweils eine geeignete Abgewandelte Ausführung ausgetauscht werden.

Der Thermostat ist so ausgelegt, das er in dem Bereich um die Plastifizierungstemperatur möglichst genau auf eine Solltemperatur einstellbar ist und diese auch bei Beschickung der Pultplatte mit einer Schaltungsplatte schnell und in engen Grenzen wieder einstellt. Um eine homogene Temperatur zu gewährleisten und eine schnelle Aufheizung einer Schaltungsplatte zu gewähren, ist der Heizbereich 11 aus einer 5 - 10 mm dicken Leichtmetallplatte hergestellt.

Fig. 5 zeigt einen schematischen Verfahrensablauf, der in drei Teilprozessen I, II, III aufgeteilt ist.

Das Lötmittel LM wird im Plastifizierer P aus Metallpulver ME, Bindemittel BM und Pastifizierungsmittel PM und mit Wärme W aufbereitet und der Siebdruckanlage SD zugeführt, wo das Lötgut LG beschichtet, d. h. bedruckt wird.

Danach wird die Bedruckung des Lötgutes einer Verfestigung F durch Abkühlung K unter die Plastifizierungstemperatur TP und durch Entzug des Plastifizierungsmittels PM1 unterzogen, und es kann dann einem Lager L oder Transport T zugeführt werden.

In dem zweiten Verfahrensabschnitt II, der mehrfach wiederholt werden kann, wird in einer Heizzone HZ eine Bestückung mit Bauelementen BE nach einer Aufheizung durch Zufuhr von Wärme W1 auf eine Temperatur etwas über die Plastifizierungstemperatur TP vorgenommen. Dieser Abschnitt endet wieder mit einer Verfestigung F1 des Lötmittels durch Abkühlung K1 unter die Plastifizierungstemperatur TP. Es schließen sich eine Zwischenlagerung L1 und Transporte T1 an, wonach das Lötgut in einer Lötzone LZ durch Zufuhr von Wärme W2 über die Verflüchtungstemperatur TF erwärmt und das Bindemittel DM1 verflüchtigt wird. Daran schließt sich die Verfestigung F2 des Lotes durch Abkühlung K2 unter die Löttemperatur TL an.

Für die Verfahrensvariante, daß die Bauelemente mit Lötmittel beschichtet werden, sind entsprechend die Eingangsgrößen Lötgut LG und Bauelemente BE zu tauschen.

Aufbereitete Naturstoffe sind sehr gut als Bindemittel geeignet und zwar Gemische natürlicher Harze, insbes. aus Aldehyden und Ketone, Kolophoniumderivate und Terpenen.

## Patentansprüche

1. Lötmittel (LM), bestehend aus

(a) einem ersten Anteil aus einer sehr feinkörnigen Blei-Zinn-Lötmetall-Legierung (ME)

(b) einem zweiten Anteil aus einem organischen Bindemittel (BM),

das aus einem derartigen Gemisch von Aldehyden, Ketonen, Koplhoniumderivaten und Terpenen gebildet ist, welches oberhalb einer Verflüchtigungstemperatur (TF) von ca. 200°C praktisch rückstandslos zu verflüchtigen ist und

das eine Plastifizierungstemperatur (TP) von ca. 60°C aufweist, wobei es oberhalb der Plastifiziertungstemperatur (TP) eine zähflüssige Konsistenz aufweist, und unterhalb von (TP) fest ist und

(c) einem dritten Anteil aus einem Plastifizierungsmittel (PM1),

das dem Lötmittel eine pastöse, siebdruckfähige Konsistenz mit einer vorgegebenen Topfzeit verleiht.

2. Lötmittel (LM) nach Anspruch 1, dadurch gekennzeichnet, daß die Blei-Zinn-Lötmetall-Legierung (ME) zusätzlich noch Wismut- und/oder Silberanteile enthält.

3. Lötmittel (LM) nach Anspruch 1 oder 2, dadurch gekennzeichnet, daß das Pastifizierungsmittel (PM1) ein Lösungsmittel des Bindemittels (BM) ist.

4. Verfahren zur Verwendung des Lötmittels (LM) nach einem der Ansprüche 1 bis 3, bei dem dieses

(a) in einem ersten Verfahrensschritt (I) in einem Siebdruckverfahren (SD), Lötmittelstellen (3, 31, 32) bildend, auf eine gedruckte Schaltung (2) aufgebracht wird, wonach das Pastifizierungsmittel (PM1) verdampft wird, und

(b) in einem zweiten Verfahrensschritt (II) diese mit dem Lötmittel (LM) bedruckte Schaltung (2) in einer Heizzone (HZ) über die Plastifizierungstemperatur (TP) erwärmt wird und dann mit elektronischen Bauelemente (4, 5a, 5b, 5c) bestückt wird, wobei deren Kontakte (51, 52) auf die plastifizierten Lötmittelstellen (3, 31, 32) zu liegen kommen, und

(c) in einem dritten Verfahrensschritt (III) diese mit den Bauelementen (4, 5a, 5b, 5c) bestückte Schaltung (2) in einer Lötzone (LZ) über eine Löt- und die Verflüchtigungstemperatur (TF) so lange erwärmt wird, bis eine vollständige Verflüchtigung des Bindemittels (BM) erfolgt ist.

5. Verfahren nach Anspruch 4, dadurch gekennzeichnet, daß vor und/oder nach dem zweiten Verfahrensschritt (II) die Schaltung (2) mit dem Lötmittel (LM) eine Abkühlung (K, K1) unter die Schmelztemperatur (TP) erfährt.

6. Verfahren nach Anspruch 5, dadurch gekennzeichnet, daß der zweite Verfahrensschritt (II), jeweils gefolgt von einer Abkühlung (K1) unter die Schmelztemperatur (TP), wiederholt erfolgt.

## Claims

1. Soldering material (LM) consisting of

(a) a first part of a very fine granular lead-tin soldering metal alloy (ME),

(b) a second part of an organic binding compound (BM),

which is composed of such a mixture of aldehydes, ketones, derivates of colophony and terpenes, that said mixture evaporates above of an evaporation temperature (TF) of approximately 200°C, whereby nearly no remainder being left,

and which mixture has a plastification temperature of approximately 60°C, whereat the said mixture has a high viscous consistency higher than the plastification temperature (TP), and below of which plastification temperature (TP) said mixture is solid, and

(c) a third part of a pastification compound (PM1) providing a pasty, screen printable consistency with a given potting time of the soldering material (LM).

2. Soldering material according to claim 1, characterized in, that the lead-tin soldering metal alloy (ME) contains an additional part of bismuth and/or silver.

3. Soldering material (LM) according to claim 1 or 2, characterized in, that the pastification compound (PM1) is a solving means of the binding compound (BM).

4. Method for using the soldering material (LM) of one of the claims 1 to 3 in which method the soldering material (LM)

(a) in a first process step (I) it is deposited on a printed circuit (2) by a screen printing process (SD), wereby soldering material spots (3, 31, 32) are generated, whereafter the pastification compound (PM1) is evaporated, and

(b) in a second process step (II) the said printed circuit (2) carrying said soldering material (LM) is heated over the plastification temperature (TP) and then electronic components (4, 5a, 5b, 5c) are attached to said printed circuit (2), whereby the contacts (51, 52) of said electronic components (4, 5a, 5b, 5c) are touching the soldering spots (3, 31, 32) and

(c) in a third process step (III) said printed circuit board (2) with the attached components (4, 5a, 5b, 5c) are heated in a soldering zone (LZ) over a soldering temperature and the evaporation temperature (TF) until a complete evaporation of the binding compound (BM) is reached.

5. Method according to claim 4, characterized in, that to the circuit (2) carrying the soldering material (LM) before and/or after the second process step (II) a cooling procedure (K, K1) is applied cooling it to a ternperature below of the melting temperature (TP).

6. Method according to claim 5, characterized in, that the second process step (II) is reperatedly performed, each time followed by a cooling procedure (K1) to a temperature below of the melting temperature (TP).

## Revendications

1. Agent thermoplastique de brasage (LM), composé

a) d'une première part consistant en un alliage métallique de brasage plomb-étain (ME) de granulométrie très fine,

b) d'une deuxième part consistant en un liant organique (BM), formé par un mélange d'aldéhydes, de cétones, de dérivés de colophane et de terpènes, volatilisable pratiquement sans résidus au-dessus d'une température de volatilisation (TF) d'environ 200 degrés C, et possédant une température de plastification (TP) d'environ 60 degrés C, sa consistance étant visqueuse au-dessus de la température de plastification (TP) et solide au-dessous de cette température de plastification (TP), et

c) d'une troisième part consistant en un agent de pastification (PM1) conférant à l'agent de brasage (LM) une consistance pâteuse apte à la sérigraphie et possédant une durée de conservation en pot prédéterminée.

2. Agent thermoplastique de brasage (LM) selon revendication 1, caractérisé par le fait que l'alliage métallique de brasage plomb-étain (ME) contient en supplément du bismuth et/ou de l'argent.

3. Agent thermoplastique de brasage (LM) selon revendication 1 ou 2, caractérisé par le fait que le pastifiant (PM1) est un solvant du liant (BM).

4. Procédé d'utilisation de l'agent thermoplastique de brasage (LM) selon l'une des revendications 1 à 3 à l'aide duquel celui-ci

a) est appliqué dans une première phase du procédé (I) en sérigraphie (SD) sur une plaque de circuits imprimés (2) en formant des points d'agent de brasage (3, 31, 32), ce après quoi l'agent de pastification (PM1) est volatilisé, et

b) cette plaque de circuits imprimés (2) pourvue de l'agent de brasage (LM) est chauffée, au cours d'une seconde phase du procédé (II), dans une zone de chauffage (HZ), à une température supérieure à la température de plastification (TP), puis équipée avec des éléments de construction électroniques (4, 5a, 5b, 5c), leurs contacts (51, 52) étant amenés sur les pastilles d'agent de brasage plastifiées (3, 31, 32) et

c) cette plaque de circuits imprimés (2) équipée avec les éléments de construction (4, 5a, 5b, 5c) est chauffée, au cours d'une troisième phase du procédé (III), dans une zone de brasage (LZ), à une température supérieure à la température de brasage et de volatilisation (TF) jusqu'à obtention d'une évaporation complète du liant (BM).

5. Procédé selon revendication 4, caractérisé par le fait qu'avant et/ou après la seconde phase du procédé (II), la plaque de circuits imprimés (2), pourvue de l'agent thermoplastique de brasage (LM) est soumise à une réfrigération (K, K1) à une température inférieure à la température de fusion (TP).

6. Procédé selon revendication 5, caractérisé par le fait que la seconde phase du procédé (II), suivie chaque fois d'un refroidissement (K1) à une température inférieure à la température de fusion (TP), est réitérée.

Fig.1

Fig.2

Fig.3

1

Fig.4

Fig.5